Europäisches Patentamt

European Patent Office

Office européen des brevets

(11) Numéro de publication: **0 385 214 B1**

(12) **FASCICULE DE BREVET EUROPEEN**

(45) Date de publication de fascicule du brevet: **18.05.94** (51) Int. Cl.5: **H03M 13/12**

(21) Numéro de dépôt: **90103136.9**

(22) Date de dépôt: **19.02.90**

(54) **Codeur/décodeur correcteur d'erreur pour installation de transmission numérique.**

(30) Priorité: **24.02.89 FR 8902407**

(43) Date de publication de la demande:
**05.09.90 Bulletin 90/36**

(45) Mention de la délivrance du brevet:
**18.05.94 Bulletin 94/20**

(84) Etats contractants désignés:
**DE ES FR GB IT NL SE**

(56) Documents cités:
**FR-A- 2 616 986**
**US-A- 3 842 400**

**IEE PROCEEDINGS F. COMMUNICATIONS, RADAR & SIGNAL vol. 132, no.2, avril 1985, STEVENAGE GB, pages 77-83; I.S.REED & T.K.TRUONG: "ERROR-TRELLIS SYNDROME DECODING TECHNIOUES FOR CONVOLUTIO-NAL CODES"**

**IEEE TRANSACTIONS ON INFORMATION THEORY. vol. IT-9, juillet 1963, NEW YORK US, pages 143-156; A.D.WYNER & R.B.ASH: "ANALYSIS OF RECURRENT CODES"**

**IEEE TRANSACTIONS ON COMPUTERS. vol. C-35, no. 9, septembre 1986, NEW YORK US**

**pages 781 - 789; I.S. REED ET AL.: "THE VLSI DESIGN OF AN ERROR-TRELLIS SYNDROME DECODER FOR CERTAIN CONVOLUTIONAL CODES."**

**IEEE JOURNAL ON SELECTED AREAS IN COMMUNICATION. vol. 6, no. 3, avril 1988, NEW YORK US pages 547 - 557; D. HACCOUN ET AL.: "NEW ARCHITECTURES FOR FAST CONVOLUTIONAL ENCODERS AND THRES-HOLD DECODERS."**

(73) Titulaire: **ALCATEL TELSPACE**
**5, rue Noel Pons**
**F-92734 Nanterre Cédex(FR)**

(72) Inventeur: **Kamanou, Pierre-François**
**79, rue Henri Barbusse**
**F-93300 Aubervilliers(FR)**
Inventeur: **Caquot, Christian**
**50, rue Louis Blanc**
**F-92400 Courbevoie(FR)**

(74) Mandataire: **Weinmiller, Jürgen et al**
**Lennéstrasse 9**
**Postfach 24**
**D-82336 Feldafing (DE)**

## Description

La présente invention se rapporte à un codeur/décodeur correcteur d'erreur pour installation de transmission numérique en particulier par faisceau hertzien.

L'introduction d'un codage correcteur d'erreur dans les faisceaux hertziens numériques utilisés dans les transmissions civiles a pour but de corriger les erreurs isolées qui proviennent par exemple des dispositifs d'allumage des véhicules automobiles.

Afin de réduire au mieux les perturbations entre canaux, l'augmentation de débit due au codage correcteur d'erreur ne doit pas dépasser environ 3 % du débit initial résultant du multiplexage du débit principal, des informations supplémentaires d'exploitation et de maintenance, et des trains additionnels s'ils existent. Ce n'est que sous cette condition que les caractéristiques de filtrage de la chaîne de transmission du matériel existant avant l'introduction de ce codage peuvent être conservées : il est alors possible, par simple échange des seules cartes-trames de passer d'une version non codée à une version codée du matériel. Dans ces applications, il convient donc de choisir, parmi les nombreux codes correcteurs d'erreur existant dans la littérature, un code correcteur d'erreur simple à faible taux de redondance.

En outre, il est avantageux, dans ce genre d'application, d'utiliser un code correcteur d'erreur qui soit ipso-facto transparent à l'ambiguïté de phase (ce qui se matérialise, comme on le sait, par le fait que le complément à 2 d'un mot du code appartient aussi au code).

Il est enfin avantageux que le code correcteur d'erreur choisi puisse être appliqué à tous les faisceaux hertziens, quel que soit le type de modulation utilisé : à 4, 16, 64, voir même 256 états de phase.

Tous ces impératifs ont amené les inventeurs à choisir, parmi les codes correcteurs d'erreur existant dans la littérature, le code de WYNER - ASH.

Ce code est par exemple décrit dans l'ouvrage de l'auteur russe ALEXANDRU SPATARU "Fondements de la théorie de la transmission de l'information", publié en France par les "Presses Polytechniques Romandes, 1987, p 132 à 136.

Une autre publication par I.S. REED et T.K. Truong portant sur le code de Wyner-Ash se trouve dans IEE PROCEEDINGS FOR COMMUNICATIONS, RADAR & SIGNAL, vol. 132, no. 2, avril 1985, pages 77 - 83: "Error-Trellis Syndrome decoding techniques for convolutional codes".

Il s'agit d'un code convolutif systématique qui permet de corriger une erreur et une seule dans toute la longueur de contrainte, quelle que soit la position qu'elle occupe dans un bloc.

Ses trois paramètres : k (nombres de bits d'information à l'entrée du codeur), n (nombre de bits en sortie de ce codeur), et m (ordre de la mémoire de retard que comprend ce codeur) sont définis par les relations suivantes :

$$k = 2^p - 1$$
$$n = k + 1$$
$$m = p + 1$$

où p est un nombre entier.

Dans le cas considéré, il a été expliqué ci-dessus que le taux de redondance du code ne doit pas sensiblement dépasser 3 %, ce qui conditionne le choix de ce nombre p. Le calcul montre dans ces conditions qu'il faut choisir un entier p supérieur ou égal à 5. En particulier, si l'on choisit p égal à 5, on obtient un code pour lequel k = 31 et n = 32, ce qui donne un taux de redondance, acceptable, de 3,2 %.

Ce code est tel que le bit de contrôle $Y_i$ d'un bloc de n bits qui sort du codeur à l'instant i est calculé en fonction des k autres bits du même bloc à cet instant i ($X_{i,1}$ ; $X_{i,2}$ ; $X_{i,3}$ ;...; $X_{ik}$), en fonction de ces mêmes k autres bits à l'instant i - 1 ($X_{i-1,1}$ ; $X_{i-1,2}$ ;...; $X_{i-1,k}$), etc..., et finalement en fonction de ces mêmes k autres bits à l'instant i - m ($X_{i-m,1}$ ;...; $X_{i-m,k}$), en réalisant l'addition modulo 2 de tous les k autres bits présents aux instants i, i - 1,..., i - m, et affectés respectivement chacun d'un coefficient A, égal à zéro ou à un, qui est défini par la matrice de génération du code.

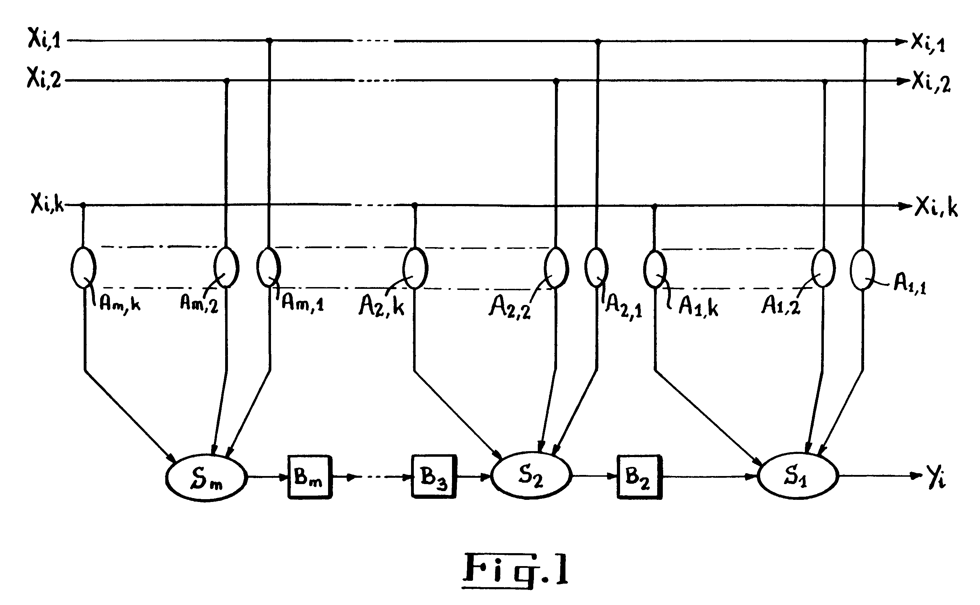

Ce mode de calcul du bit de contrôle $Y_i$ est, pour plus de clarté, schématisé sur la figure 1 jointe. Sur ce schéma les k bits ($X_{i,1}$ ; $X_{i,2}$ ;...; $X_{i,k}$) qui entrent dans le codeur à l'instant i sont placés sur la gauche du dessin, tandis que les (k + 1) bits ($X_{i,1}$ ; $X_{i,2}$ ;...; $X_{i,k}$ ; $Y_i$) qui en sortent à ce même instant i se trouvent sur la droite de ce dessin.

Le bit de contrôle $Y_i$ est la sortie d'un additionneur binaire S1 qui reçoit lui-même les k bits d'entrée, affectés chacun respectivement d'un coefficient A 1.1 ; A1,2 ;...; A1,k, qui est d'ailleurs toujours égal à 1, et qui reçoit la sortie d'une bascule de comptage B2.

Cette bascule de comptage B2 reçoit elle-même la sortie d'un autre sommateur binaire S2. Les entrées de ce sommateur S2 sont elles-aussi constituées par, d'une part, les k bits d'entrée, affectés chacun respectivement d'un coefficient respectif A2,1 ; A2,2 ;...; A2, k, qui est égal à 0 ou 1 et qui est défini par la matrice de génération du code, et par, d'autre part, la sortie d'une autre bascule de comptage B3, et ainsi de suite jusqu'à l'additionneur "modulo 2" Sm, dont la sortie attaque la bascule de comptage Bm, et qui reçoit pour sa part uniquement les k bits d'entrée prédéfinis, affectés chacun d'un coefficient respectif Am,1 ; Am,2 ;...; Am, k, qui est là encore égal à 0 ou 1 et qui est défini par la matrice de génération du code, qui est donc la suivante :

```
R1 = A1,1      A1,2  ................ A1,k

R2 = A2,1      A2,2  ................ A2,k

.....................................................

Rm = Am,1      Am,2  ............... Am,k
```

avec la remarque que les coefficients de la première ligne R1 de cette matrice (A1,1 à A1,k) sont tous égaux à 1.

L'application directe de ce principe de codage aux transmissions numériques par faisceau hertzien nécessiterait, en amont du codeur, une conversion série-parallèle et, en aval de ce codeur, une conversion parallèle-série, du fait que le codeur de WYNER-ASH est à priori un codeur parallèle, comme il ressort de toute évidence de la figure 1. Ceci aurait pour inconvénient une réalisation lourde et onéreuse.

L'invention vise à remédier à cet inconvénient. Elle se rapporte à cet effet à un dispositif de codage correcteur d'erreur pour installation de transmission numérique en particulier par faisceau hertzien, ce dispositif utilisant un code correcteur d'erreur de Wyner-Ash dont le nombre entier p ci-dessus défini est au moins égal à 5 (soit : m au moins égal à 6). Ce codeur utilise m registres à décalage en série, dont au moins les p premiers comportent chacun n bascules, les sorties des k premières bascules du premier de ces registres à décalage étant reliées à un premier circuit OU EXCLUSIF, les K premières sorties du deuxième registre à décalage étant reliées à un deuxième circuit OU EXCLUSIF si elles correspondent à un coefficient (A2,1 ; A2,2 ;...; ou A2,k) de la deuxième ligne de la matrice précitée de génération du code égal à 1, et n'étant pas connectées lorsqu'elles correspondent à un coefficient égal à 0, et ainsi de suite jusqu'au m-ième registre à décalage, lui-même associé de la même façon à un m-ième circuit OU EXCLUSIF, les m sorties de ces m circuit OU EXCLUSIF étant toutes reliées à un autre circuit OU EXCLUSIF dont la sortie est appliquée à l'une des deux entrée d'un multiplexeur d'entrée du codeur, ce multiplexeur recevant sur son autre entrée les séquences successives constituées chacune par k bits d'information, suivis d'un espace apte à recevoir un bit de contrôle, l'entrée de commande de ce multiplexeur étant un signal périodique qui est apte à relier sa sortie au fil d'amenée des k bits d'information pendant le passage de ces k bits et à la sortie de cet autre circuit OU EXCLUSIF pendant l'espace réservé à l'insertion du bit de contrôle, cette sortie du multiplexeur attaquant d'une part le premier registre à décalage, et d'autre part une bascule de repointage dont la sortie forme la sortie de ce codeur-série de WYNER-ASH.

L'invention peut aussi comporter un décodeur-série, apte à être utilisé dans une installation de transmission numérique équipée de ce codeur, ce décodeur-correcteur d'erreur comportant m registres à décalage en série, parmi lesquels les k premiers comportent chacun n bascules et le dernier comporte au moins n bascules dont les entrées des k dernières sont chacune reliées à la sortie de la bascule précédente par un circuit OU EXCLUSIF respectif également attaqué par une entrée extérieure et dont la dernière est la bascule de sortie du décodeur, les sorties de ces registres étant reliées respectivement à m circuits OU EXCLUSIF exactement de la même façon que celles relatives au registres à décalage du codeur précité, et les m sorties de ces circuits OU EXCLUSIF étant de la même façon reliées à un autre circuit OU EXCLUSIF, la sortie de ce dernier étant connectée, à travers une porte rendue passante par le signal périodique précité (commandant le multiplexeur d'entrée du codeur), à un circuit OU EXCLUSIF à deux entrées, l'autre entrée de ce dernier circuit OU EXCLUSIF étant constituée par le train de signaux numériques reçus qui est appliqué au décodeur, et sa sortie étant reliée d'une part à l'entrée du premier registre à décalage et d'autre part à un décodeur binaire-décimal auquel sont également reliées les sorties des (p - 1) premiers registres à décalage et qui est validé par le signal de sortie du p-ième registre à décalage à travers une porte ET qui reçoit également au moins le signal périodique précité, les k premières sorties de ce décodeur binaire-décimal (dont une d'entre elles donne la position de l'erreur) étant respectivement appliquées aux entrées extérieures précitées des circuits OU EXCLUSIF précédant chacun une des k dernières bascules du dernier registre à décalage, de fa on à corriger l'erreur se trouvant momentanément stockée dans ce registre, tandis que simultanément le signal de validation du décodeur binaire-décimal est utilisé pour effectuer la remise à zéro de la première bascule de chacun des p premiers registres à décalage afin d'effacer les bits de syndrome qu'elles contiennent et qui indiquent à eux tous la position de l'erreur simultanément corrigée.

De toute façon, l'invention sera bien comprise, et ses avantages et autres caractéristiques ressortiront, lors de la description suivante d'un exemple non limitatif de réalisation de ce codeur-décodeur série de WYNER-ASH, en référence au dessin schématique annexé dans lequel :

- Figure 2 est un schéma du codeur ;
- Figure 3 est un schéma du décodeur ; et
- Figure 4 est un schéma du dernier registre à décalage équipant ce décodeur

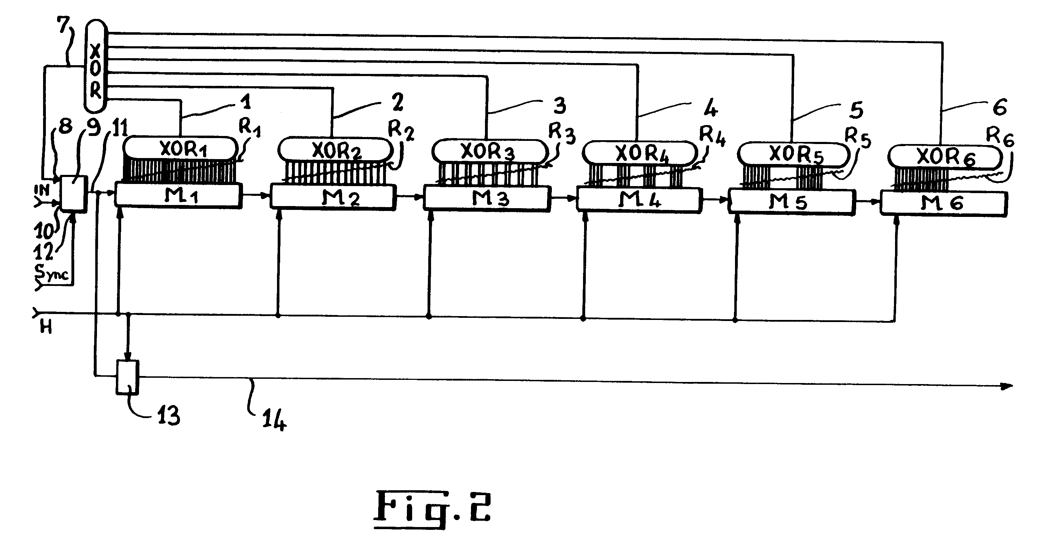

En se reportant tout d'abord à la figure 2, ce codeur-série est applicable au code de WYNER-ASH pour lequel le nombre entier p précité est égal à 5, ce qui donne pour ce code un taux de redondance de 3,2%. Les trois paramètres de ce code sont donc :

$$k = 2^p - 1 = 31$$
$$n = k + 1 = 32$$
$$m = p + 1 = 6$$

Sa matrice de génération est constituée par les six lignes R1 à R6 suivantes :

R1 : 1111111111111111111111111111111

soit 31 fois le coefficient "1"

R2 : 1010101010101010101010101010101

soit alternativement un "1" et un "0"

R3 : 1100110011001100110011001100110

soit des suites de deux "1" séparées par deux "0"

R4 : 1111000011110000111100001111000

soit des suites de quatre "1" séparées par quatre "0"

R5 : 1111111100000000111111110000000

soit des suites de huit "1" séparées par huit "0"

R6 : 1111111111111111000000000000000

soit une suite de seize "1" suivie par quinze "0" Le codeur-série comporte six registres à décalage en série, références M1 à M6 sur la figure 2. Il s'agit de registres à chacun n bascules, soit en l'espèce 32 bascules.

Les sorties des 31 premières bascules du premier registre M1 sont affectées des coefficients respectifs définis par la première ligne R1 de la matrice de génération, et sont par suite toutes connectées à un premier circuit "OU EXCLUSIF" XOR1.

De même, les 31 premières sorties du deuxième registre M2 sont reliées à un deuxième circuit "OU EXCLUSIF" XOR2 lorsqu'elles correspondent à un coefficient de la ligne R2 égal à 1, tandis qu'elles ne sont pas connectées lorsqu'elles correspondent à un coefficient de cette ligne R2 égal à 0, de sorte qu'une sortie sur deux est finalement connectée à XOR2.

En continuant de la même façon jusqu'au dernier registre M6, on constate que la répartition de celles des 31 premières sorties des registres suivants M3 à M6 qui sont connectées à un circuit OU EXCLUSIF, respectivement XOR3 à XOR6, est définie par la répartition des "1" dans les lignes respectives R3 à R6 de la matrice : successivement donc par des groupes de deux sorties séparés l'un de l'autre par des espaces de deux sorties non connectées, puis des groupes de quatre sorties séparés par des espaces de largeurs égales à quatre sorties, puis des groupes de huit séparés par huit unités, puis un seul bloc de seize (à ce sujet, il convient de remarquer que le dernier registre M6 peut être un registre à 16 bascules, puisque les 16 bascules suivantes ne sont pas du tout utilisées).

Les six sorties respectives, 1 à 6, des six circuits OU EXCLUSIF XOR1 à XOR6 sont toutes reliées à un autre circuit "OU EXCLUSIF" XOR dont la sortie 7 est appliquée à l'entrée 8 d'un multiplexeur 9 à deux entrées 8, 10, une sortie 11, et une borne de commande 12 apte à connecter la borne 11 soit à la borne 10 soit à la borne 8 selon que le signal "Sync" qui lui est appliqué a respectivement pour valeur "0" ou "1".

La borne 10 reçoit le train d'information IN, qui est constitué de séries de 31 bits d'information séparées l'une de l'autre par à chaque fois un espace, préparé en amont par le bloc mémoire-tampon et apte à recevoir un extra-bit de contrôle.

Le signal Sync est égal à zéro pendant le passage des 31 bits d'information précités et il passe à 1 pendant l'espace précité, destiné à l'insertion d'un extra-bit de contrôle.

La sortie 11 du multiplexeur d'entrée 9 est d'une part connectée à l'entrée du premier registre à décalage M1, et elle est d'autre part connectée à une bascule D de repointage 13 dont la sortie 14 est la

4

sortie du codeur.

Comme il va de soi, les six registres en cascade M1 à M6 et la bascule 13 sont tous synchronisés par le signal d'horloge H du train d'information IN.

Le fonctionnement de ce codeur est le suivant : A la mise sous tension, tous les registres M1 à M6 sont initialisés à zéro. Cette initialisation permet d'expliquer le fonctionnement du codeur, et n'interviendra plus par la suite puisque le codage ne deviendra valable qu'àprès le passage des 192 premiers bits, comme on le verra ci-après.

L'initialisation est supposée prendre fin lorsque le signal Sync est activé à "1" (durée de l'impulsion Sync: une période d'horloge H). Le début du message à coder correspond alors au front descendant de cette impulsion Sync, dont le retour au niveau "O" active alors, par l'intermédiaire du multiplexeur d'entrée 9, la réception des données dans le registre M1.

Après le passage d'une première séquence de 31 bits, le signal Sync repasse à "1" pendant une période d'horloge : la sortie 11 du multiplexeur 9 est alors reliée à l'entrée 8, c'est à dire à la sortie 7 du circuit XOR. Les circuits XOR2 à XOR6 ayant leurs sorties à zéro, il s'ensuit que le signal qui s'insère au 32ème coup d'horloge dans la première bascule du registre M1 est l'addition module 2 des 31 premiers bits d'information précédemment rentrés dans le registre. Ce signal donne donc le bit de contrôle.

Ce processus se poursuit jusqu'à ce que les six registres M1 à M6 soient intégralement remplis, ce qui a lieu après les 192 premiers coups d'horloge après l'initialisation.

Ce n'est qu'à ce moment que le codage de WYNER ASH est effectivement opérationnel, car les bits de contrôle qui sont insérés tous les 31 bits dans le message qui sort en série de la bascule 13 sont alors calculés conformément à la matrice de codage (matérialisée par les connexions R1 à R5), et selon le schéma de la figure 1 précédemment expliqué : il s'agit finalement bien là d'un codeur où les trains entrent en série en 10, sortent en série en 14, mais où le codage est réalisé en parallèle au moyen des six mémoires M1 à M6 et de leurs circuits associés.

Après le passage des 192 premiers coups d'horloge, le retard au codage n'est finalement que d'une période d'horloge, ce retard étant dû à la bascule de repointage 13.

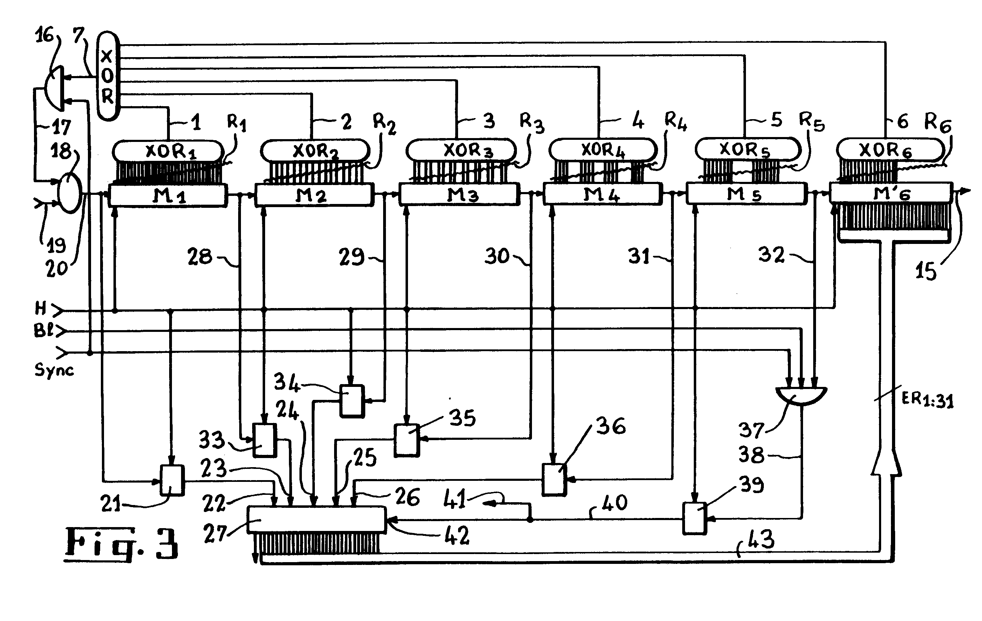

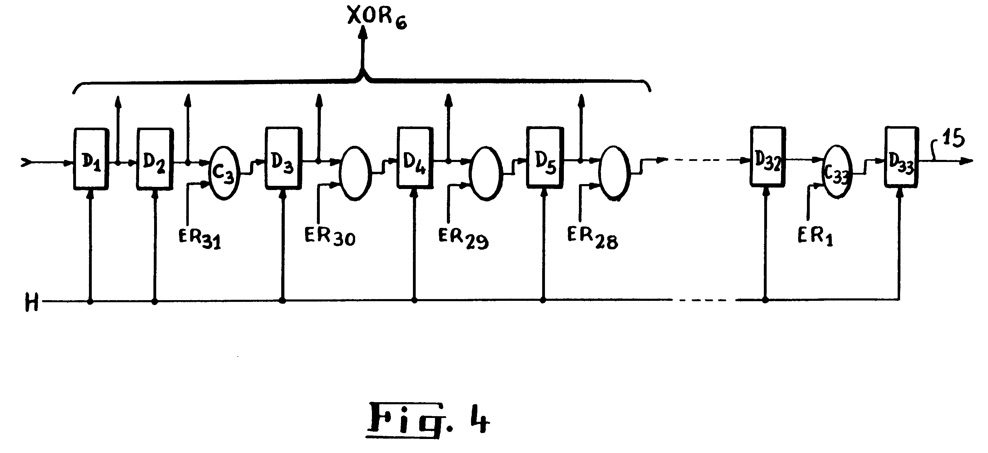

En se reportant aux figures 3 et 4 qui donnent le schéma du décodeur série associé, côté réception, au codeur d'émission de la figure 2, force est de constater que ce décodeur s'apparente en partie au codeur de la figure 2, en particulier par la présence de six registres à décalage en série M1 à M5 et M'6, parmi lesquels :

- les cinq premiers M1 à M5 sont identiques aux registres M1 à M5 du codeur, et sont de la même façon connectés à des circuits OU EXCLUSIF XOR1 à XOR5, qui sont eux-mêmes connectés de la même manière à un autre circuit OU EXCLUSIF XOR ;
- le dernier registre M'6, qui est représenté en détails sur la figure 4 est particulier : il a bien ses seize premières sorties reliées au circuit XOR6, lui même relié à XOR, mais en revanche, il comporte 33 bascules D1 à D33, dont les entrées des 31 dernières (D3 à D33) sont chacune reliées à la sortie de la bascule précédentes (D2 à D32) par un circuit OU EXCLUSIF respectif C3 à C33, qui est également attaqué par une entrée extérieure, respectivement ER31 à ER1 qui, comme on le verra ultérieurement, représente éventuellement l'adresse du bit erroné à corriger ; la sortie 15 de la dernière bascule est la sortie du décodeur, tandis que, bien entendu, toutes les bascules des registres M1 à M'6 reçoivent le signal d'horloge H précité.

La sortie 7 du circuit XOR est connectée à une porte ET 16, dont l'autre entrée reçoit le signal Sync précité, et dont la sortie 17 est reliée à une première entrée d'un circuit "OU EXCLUSIF" 18 qui reçoit également, sur son autre entrée 19, le train d'information numériques à décoder : la borne 19 constitue donc l'entrée du décodeur.

La sortie 20 du circuit 18 est reliée d'une part à l'entrée du premier registre à décalage M1, et d'autre part, à travers une bascule D 21 recevant elle-aussi l'horloge H, à la première des cinq entrées 22 à 26 d'un convertisseur binaire-décimal 27. Les sorties 28 à 31 des registres M1 à M4 (ou, autrement dit, les entrées des registres M2 à M5) sont respectivement reliées aux entrées 23 à 26 de ce convertisseur binaire-décimal 27, à travers des bascules D respectives 33 à 36, elles aussi synchronisées par le signal d'horloge H.

Les 31 dernières sorties ER31 à ER1 du convertisseur 27 sont connectées aux entrées extérieures précitées des circuits OU EXCLUSIF C3 à C33 (voir la figure 4) inclus dans le registre M'6.

La sortie 32 du registre M5 attaque une porte 37, qui reçoit également le signal Sync précité ainsi qu'éventuellement un signal extérieur B1 de commande de blocage de correction. La sortie 38 de cette porte 37 attaque une bascule D39, elle aussi synchronisée par l'horloge H. La sortie 40 de la bascule 39 fournit d'une part en 42 un signal de validation du convertisseur binaire-décimal 27, et d'autre part en 41 un signal de remise à zéro de la première bascule de chacun des registres M1 à M5.

5

Le fonctionnement de ce décodeur-série de WYNER-ASH est le suivant :

A la réception des 31 premiers bits d'information reçus sur l'entrée 19, le signal Sync est au niveau "0", de sorte que la porte 16 est fermée et que les signaux en 19 sont transmis en 20 vers le premier registre à décalage M1, dont ils remplissent les 31 premiers bascules.

Lorsque le 32-ième bit arrive, on sait qu'il s'agit du bit de contrôle. Le signal Sync passe donc au niveau "1", ce qui ouvre la porte 16. Par suite, un autre bit de contrôle calculé par le circuit XOR1 est appliqué en 17 à la porte OU EXCLUSIF 18 en même temps que le bit de contrôle reçu, qui est appliqué en 19. En 20 sort donc ce que l'on appelle un "bit de syndrome", qui est égal à zéro si le bit de contrôle reçu est identique au nouveau bit de contrôle recalculé, et qui est égal à 1 dans le cas contraire. En d'autres termes, un bit de syndrome égal à 1 indique la présence d'une erreur dans le message reçu. Ce bit de syndrome s'inscrit donc alors dans la première bascule du registre M1. Supposons le égal à zéro, et laissons se remplir de la même façon tous les registres jusqu'au registre M'6 par des blocs de 31 bits d'information précédés d'un bit de syndrome. Le décodeur est alors prêt à fonctionner.

Supposons maintenant qu'il apparaît une erreur dans la première séquence suivante de 32 bits reçue à l'entrée du registre M1. Lorsque cette séquence a rempli ce registre M1, il y a détection d'une erreur puisque le bit calculé en sortie de XOR est forcément différent du bit de contrôle reçu : le bit de syndrome qui entre dans la première bascule de M1 est donc égal à 1.

Cette séquence erronée remplit alors le bloc M2. Le bit de syndrome alors calculé est égal à 1 si l'erreur se trouve sur un des fils qui sont connectés au circuit XOR 2, et il est égal à zéro dans le cas contraire, et ainsi de suite jusqu'au registre M5. On voit immédiatement que, compte tenu de la répartition des coefficients 1 et 0 sur les lignes R1 à R5 de la matrice ces cinq bits calculés correspondent au codage binaire de la position de l'erreur : si l'erreur est par exemple en neuvième position dans la séquence de 31 bits d'information, la position des bits de syndrome sera la suivante :

0 1 0 0 1

ce qui correspond bien à la représentation binaire du nombre 9.

Lorsque les 31 bits de la séquence erronée sont entrés dans le registre M'6, le bit de syndrome (égal à 1) de cette séquence est appliqué à la fois à la première bascule D1 du registre M'6 et à la porte ET 37, qui se trouve alors ouverte par le fait que le signal Sync est aussi passé à 1 et que le signal BI n'est pas à l'état O, ce qui indiquerait une commande extérieure de blocage de correction.

Le niveau "1" qui sort en 38 est alors enregistré dans la bascule 39, comme par ailleurs sont à ce moment enregistrés les cinq bits de syndrome en 20, 28, 29, 30 et 31 dans les bascules D respectives 21, 33, 34, 35 et 36, ces cinq bits de syndrome étant le représentation binaire de la position de l'erreur dans la séquence maintenant enregistrée dans le bloc M'6.

Au coup d'horloge suivant, le convertisseur binaire-décimal 27 est validé par la sortie 40 de la bascule 39, tandis que les sorties 22 à 26 des cinq autres bascules D lui sont appliquées. Les 31 derniers fils de sortie du circuit 27 sont respectivement appliqués, par le bus 43, aux entrées ER1 à ER31 des circuits additionneurs C33 à C3 (figure 4), de sorte que la sortie activée du circuit 27, qui représente la position décimal de l'erreur, va, par l'intermédiaire du circuit OU EXCLUSIF correspondant, corriger l'erreur dans la bascule du registre M'6 où elle se trouve.

A remarquer, comme on le voit sur la figure 3, que le fil de gauche en sortie du circuit 27 n'est pas relié, car il correspondrait à une erreur sur le bit de contrôle, qui n'est bien entendu pas corrigé puisqu'il ne présente plus aucun intérêt à la sortie du décodeur.

Dans le même temps, les premières bascules des registres M1 à M5 sont remises à zéro par le niveau 1 qui se trouve sur le fil 41, de façon à effacer les cinq bits de syndrome pour ne pas provoquer de correction intempestive par ces bits de syndrome : ces derniers, qui indiquent la position de l'erreur, doivent être effacés pour ne pas provoquer à nouveau des corrections d'erreur non justifiées.

La séquence rectifiée sort finalement en 15, avec un retard au décodage égal à 193 coups d'horloge. Bien entendu, ce fonctionnement est rendu possible par le fait que, par définition, le code ne peut corriger qu'une seule erreur dans toute la longueur de contrainte (192 bits).

Le processus est alors renouvelé, et se poursuit indéfiniment, avec possibilité de correction d'une erreur dans chaque longueur de contrainte de 192 bits.

Il convient de remarquer que le codeur et le décodeur ont une structure assez proche. En conséquence, un bloc codeur/décodeur de WYNER-ASH pouvant réaliser les deux fonctions peut être développé dans un circuit prédiffusé du genre ASIC. Ce module peut ainsi facilement s'adapter aux trames dans les modulation MDP4, MAQ16, MAQ64 et MAQ256, en traitant indépendamment chaque train.

Comme il va de soi, l'invention n'est pas limitée à l'exemple de réalisation qui vient d'être décrit. C'est ainsi que les bascules 21, 33 à 36, 39 et D33, qui ont pour utilité de permettre d'effectuer tout le calcul en deux coups d'horloge au lieu d'un seul ainsi que de permettre un repointage du signal, auraient pu être omise dans d'autres conditions technologiques, et le registre M'6 raccourci en conséquence.

**Revendications**

**1.** Dispositif de codage/décodage correcteur d'erreur pour installation de transmission numérique, ce dispositif utilisant un code correcteur d'erreur de WYNER-ASH dont l'ordre m de la mémoire de retard est au moins égal à 6, les deux autres paramètres du code étant :

k (nombre de bits d'information à l'entrée) = $2^p$ - 1
n (nombre de bits en sortie) = k + 1
avec m = p + 1,

caractérisé en ce qu'il est équipé d'un codeur comportant m registres à décalage (M1 à M6) en série, dont au moins les p premiers (M1 à M5) comportent chacun n bascules, les sorties des k premières bascules du premier (M1) de ces registres à décalage étant reliées à un premier circuit OU EXCLUSIF (XOR1), les k premières sorties du deuxième registre à décalage (M2) étant reliées à un deuxième circuit OU EXCLUSIF (XOR2) si elles correspondent à un coefficient (A2,1 ; A2,2, ... ; A2, k) de la deuxième ligne (R2) de la matrice de génération du code égal à 1, et n'étant pas connectées lorsqu'elles correspondent à un coefficient égal à 0, et ainsi de suite jusqu'au m-ième registre à décalage (M6), lui-même associé de la même façon à un m-ième circuit OU EXCLUSIF (X0R6), les m sorties (1 à 6) de ces m circuits OU EXCLUSIF (XOR1 à XOR6) étant reliées à un autre circuit ou EXCLUSIF (XOR) dont la sortie (7) est appliquée à l'une (8) des deux entrées d'un multiplexeur (9) d'entrée du codeur, ce multiplexeur recevant sur son autre entrée (10) les séquences successives constituées chacune par k bits d'information, suivis d'un espace apte à recevoir un bit de contrôle, l'entrée de commande (12) de ce multiplexeur (9) étant un signal périodique (Sync) qui est apte à relier sa sortie (11) au fil d'amenée (10) des k bits d'information pendant le passage de ces k bits et à la sortie (7) de cet autre circuit OU EXCLUSIF (XOR) pendant l'espace réservé à l'insertion du bit de contrôle, cette sortie (11) du multiplexeur (9) attaquant d'une part le premier registre à décalage (M1), et d'autre part une bascule de repointage (13) dont la sortie (14) forme la sortie de ce codeur-série de WYNER-ASH.

**2.** Dispositif de codage/décodage correcteur d'erreur selon la revendication 1, caractérisé en ce qu'il est équipé d'un décodeur-correcteur d'erreur comportant lui-aussi m registres à décalage (M1 à M'6) en série, parmi lesquels les k premiers (M1 à M5) comportent chacun n bascules et le dernier (M'6) comporte au moins n bascules dont les entrées des k dernières (D3 à D33) sont chacune reliées à la sortie de la bascule précédente (D2 à D32) par un circuit OU EXCLUSIF respectif (C3 à C33) également attaqué par une entrée extérieure (ER31 à ER1) et dont la dernière bascule (D33) est la bascule de sortie du décodeur, les sorties de ces registres (M1 à M'6) étant reliées respectivement à m circuits OU EXCLUSIF (XOR1 à XOR6) exactement de la même façon que celles relatives aux registres à décalage (M1 à M6) du codeur, et les m sorties de ces circuits OU EXCLUSIF étant de la même façon reliées à un autre circuit OU EXCLUSIF (XOR), la sortie de ce dernier étant connecté, à travers une porte (16) rendue passante par le signal périodique (Sync) précité, à un circuit OU EXCLUSIF (18) à deux entrées (17, 19), l'autre entrée (19) de ce dernier circuit (18) étant constituée par le train de signaux numériques reçus qui est appliqué au décodeur, et sa sortie (20) étant reliée d'une part à l'entrée du premier registre à décalage (M1) et d'autre part à un convertisseur binaire-décimal (27) auquel sont également reliées les sorties des (p-1) premiers registres à décalage (M1 à M4) et qui est validé par le signal de sortie (32) du p-ième registre à décalage (M5) à travers une porte (37) de validation qui reçoit également au moins ledit signal périodique (Sync), les k premières sorties (ER1 à ER31) de ce convertisseur binaire-décimal (dont une d'entre elles donne la position de l'erreur) étant respectivement appliquées aux entrées extérieures précitées des circuits OU EXCLUSIF (C33 à C3) précédant chacun une des k dernières bascules (D33 à D3) du dernier registre à décalage (M'6), de façon à corriger l'erreur se trouvant momentanément stockée dans ce registre (M'6), tandis que simultanément le signal (40) de validation du convertisseur binaire-décimal (27) est utilisé pour effectuer la remise à zéro de la première bascule de chacun des p premiers registres à décalage afin d'effacer les bits de syndrome qu'elles contiennent et qui indiquent à eux tous la position de l'erreur simultanément corrigée.

7

**3.** Dispositif de codage/décodage correcteur d'erreur selon la revendication 2, caractérisé en ce que la porte de validation (37) reçoit également un signal extérieur (B1) de blocage de correction.

**4.** Dispositif de codage/décodage correcteur d'erreur selon l'une des revendications 2 ou 3, caractérisé en ce que le signal de validation (38) et les signaux (20, 28 à 31) d'indication de l'adresse de l'erreur sont appliqués au convertisseur binaire-décimal au travers d'une bascule D respective (39, 21, 33 à 36).

**Claims**

**1.** An error correcting encoder/decoder system for a digital transmission installation, the system using a Wyner-Ash error correcting code whose delay memory order ($\underline{m}$) is not less than 6, with the other two parameters of the code being as follows:

$\underline{k}$ (number of input information bits) = $2^p$ - 1
$\underline{n}$ (number of output bits) = k + 1
where $\underline{m}$ = p + 1,

the system being characterized in that it is fitted with an encoder comprising $\underline{m}$ shift registers (M1 to M6) in series, with at least the $\underline{p}$ first shift registers (M1 to M5) each including $\underline{n}$ bistables, the outputs from the $\underline{k}$ first bistables of the first (M1) of these shift registers being connected to a first exclusive OR circuit (XOR1), the outputs of the $\underline{k}$ first bistables of the second shift register (M2) being connected to a second exclusive OR circuit (XOR2) if they correspond to a "1" coefficient (A2,1; A2,2; ...; A2,k) of the second row (R2) of the code to generator matrix, and being unconnected when they correspond to a "0" coefficient, and so on up to the n-th shift register (M6) which is itself associated in the same way with an m-th exclusive OR circuit (XOR6), with the $\underline{m}$ outputs (1 to 6) of these $\underline{m}$ exclusive OR circuits (XOR1 to XOR6) being connected to another exclusive OR circuit (XOR) whose output (7) is applied to one (8) of the two inputs to an input multiplexer (9) to the encoder, the other input (10) of the multiplexer receiving successive sequences each constituted by $\underline{k}$ information bits, followed by a gap suitable for receiving a check bit, the multiplexer (9) having a control input (12) receiving a periodic signal (sync) which is suitable for connecting the output (11) of the multiplexer to the input (10) conveying the $\underline{k}$ information bits while these $\underline{k}$ bits are passing, and to the output (7) of said other exclusive OR circuit (XOR) during the gap set aside for inserting the check bit, said output (11) of the multiplexer (9) feeding firstly the first shift register (M1) and secondly a synchronizing bistable (13) whose output (14) constitutes the output of the Wyner-Ash serial encoder.

**2.** An error correcting encoder/decoder system according to claim 1, characterized in that it is fitted with an error correcting decoder likewise comprising $\underline{m}$ shift registers (M1 to M'6) in series, with the first $\underline{k}$ of said shift registers (M1 to M5) each comprising $\underline{n}$ bistables, and with the last shift register (M'6) including at least $\underline{n}$ bistables with the inputs to the last $\underline{k}$ thereof (D3 to D33) each being connected to the output of the preceding bistable (D2 to D32) via a respective exclusive OR circuit (C3 to C33) also having a corresponding external input (ER31 to ER1), and with the last bistable (D33) being the output bistable from the decoder, the outputs from the shift registers (M1 to M'6) being connected to $\underline{m}$ respective exclusive OR circuits (XOR1 to XOR6) in exactly the same manner as the outputs of the shift registers (M1 to M6 in the encoder, and the $\underline{m}$ outputs from these exclusive OR circuit being connected in the same manner to another exclusive OR circuit (XOR), with the output therefrom being connected via a gate (16) which is opened by the above-mentioned periodic signal (sync) to an exclusive OR circuit (18) having two inputs (17, 19), with the other input (18) of said exclusive OR circuit (18) receiving the received stream of digital signals that is applied to the decoder, and with its output (20) being connected firstly to the input of the first shift register (M1) and secondly to a binary-to-decimal converter (27) which also has the outputs of the (p-1) first shift registers (M1 to M4) connected thereto and which is enabled by the output signal (32) from the p-th shift register (M5) via an enabling gate (37) which also receives at least said periodic signal (sync), the $\underline{k}$ first outputs (ER1 to ER31) of the binary-to-decimal converter (one of which specifies the position of the error) being connected to respective ones of the above-mentioned external inputs to the exclusive OR circuits (C33 to C3) preceding each of the $\underline{k}$ last bistables (D33 to D31) of the last shift register (M'6) in such a manner as to correct the error momentarily stored in said register (M'6), with the enable signal (40) for the binary-to-decimal converter (27) being used simultaneously to reset to zero the first bistable of each of the $\underline{p}$ first shift registers so as to clear the syndrome bits they contain and which together specify the position of the error which is simultaneously corrected.

3. An error correcting encoder/decoder system according to claim 2, characterized in that the enable gate (37) also receives an external signal (B1) for switching off error correction.

4. An error correcting encoder/decoder system according to claim 2 or 3, characterized in that the enable signal (38) and the error address specifying signals (20, 28 to 31) are applied to the binary-to-decimal converter via respective D-type bistables (39, 21, 33 to 36).

**Patentansprüche**

1. Vorrichtung zur Kodierung/Dekodierung mit Fehlerkorrektur für ein Datenübertragungssystem, wobei die Vorrichtung einen Fehlerkorrekturkode von WYNER-ASH verwendet, dessen Rang m des Verzögerungsspeichers mindestens gleich 6 ist, während die beiden anderen Parameter folgende Werte haben:

k (Anzahl der Informationsbits am Eingang): $= 2^P - 1$
n (Anzahl der Bits am Ausgang): $= k + 1$
(mit $m = p + 1$),

dadurch gekennzeichnet, daß die Vorrichtung einen Kodierer enthält, der m Schieberegister (M1 bis M6) in Reihe besitzt, von denen mindestens die p ersten (M1 bis M5) je n Kippstufen besitzen und die Ausgänge der k ersten Kippstufen des ersten (M1) dieser Schieberegister mit einem ersten EXKLUSIV-ODER-Kreis (XOR1) verbunden sind, während die k ersten Ausgänge des zweiten Schieberegisters (M2) an einen zweiten EXKLUSIV-ODER-Kreis (XOR2) angeschlossen sind, wenn sie einem Koeffizienten (A2,1; A2,2; ...; A2,k) der zweiten Zeile (R2) der Kodeerzeugungsmatrix mit dem Wert "1" entsprechen und nicht angeschlossen sind, wenn sie einem Koeffizienten mit dem Wert "0" entsprechen, usw. bis zum m-ten Schieberegister (M6), das seinerseits in gleicher Weise mit einem m-ten EXKLUSIV-ODER-Kreis (XOR6) verbunden ist, wobei die m Ausgänge (1 bis 6) dieser m EXKLUSIV-ODER-Kreise (XOR1 bis XOR6) an einen weiteren EXKLUSIV-ODER-Kreis (XOR) angeschlossen sind, dessen Ausgang (7) an einen (8) von zwei Eingängen eines Eingangsmultiplexers (9) des Kodierers angelegt ist, der an seinem anderen Eingang (10) die aufeinanderfolgenden je aus k Datenbits gefolgt von einem Abstandsplatz für ein Kontrollbit bestehenden Folgen empfängt, wobei der Steuereingang (12) dieses Multiplexers (9) ein periodisches Signal (Sync) empfängt, über das der Ausgang (11) des Multiplexers an den Eingang (10) für die k Datenbits während des Durchgangs dieser k Bits bzw. an den Ausgang (7) des anderen EXKLUSIV-ODER-Kreises (XOR) während des für die Einfügung des Kontrollbits reservierten Abstandsplatzes angeschlossen werden kann, wobei der Ausgang (11) des Multiplexers (9) einerseits an das erste Schieberegister (M1) und andererseits an eine Kippstufe (13) zur Resynchronisierung führt, deren Ausgang (14) den Ausgang des Serienkodierers nach WYNER-ASH bildet.

2. Vorrichtung zur Kodierung/Dekodierung mit Fehlerkorrektur gemäß Anspruch 1, dadurch gekennzeichnet, daß sie einen fehlerkorrigierenden Dekodierer enthält, der ebenfalls m Schieberegister (M1 bis M'6) in Reihe aufweist, von denen die k ersten (M1 bis M5) je n Kippstufen und das letzte (M'6) mindestens n Kippstufen enthält, wobei die Eingänge der k letzten Kippstufen (D3 bis D33) je an den Ausgang der vorhergehenden Kippstufe (D2 bis D32) über je einen EXKLUSIV-ODER-Kreis (C3 bis C33) angeschlossen sind, der außerdem mit einem äußeren Eingang (ER31 bis ER1) verbunden ist, während die letzte Kippstufe (D33) die Ausgangskippstufe des Dekodierers bildet, wobei die Ausgänge dieser Register (M1 bis M'6) an m EXKLUSIV-ODER-Kreise (XOR1 bis XOR6) genau in derselben Weise wie bei den Schieberegistern (M1 bis M6) des Kodierers angeschlossen sind und die m Ausgänge dieser EXKLUSIV-ODER-Kreise in gleicher Weise an einen weiteren EXKLUSIV-ODER-Kreis (XOR) angeschlossen sind, dessen Ausgang über ein vom periodischen Signal (Sync) gesteuertes Tor (16) an einen EXKLUSIV-ODER-Kreis (18) mit zwei Eingängen (17, 19) angeschlossen ist, wobei der andere Eingang (19) dieses Kreises (18) den digitalen Datenfluß empfängt, der an den Dekodierer angelegt wird, und der Ausgang (20) dieses Kreises einerseits an den Eingang des ersten Schieberegisters (M1) und andererseits an einen Binär-Dezimal-Wandler (27) angeschlossen ist, an den außerdem die Ausgänge der p-1 ersten Schieberegister (M1 bis M4) angeschlossen sind und der durch das Ausgangssignal (32) des p-ten Schieberegisters (M5) über ein Aktivierungstor (37) aktiviert wird, das außerdem mindestens das periodische Signal (Sync) empfängt, wobei die k ersten Ausgänge (ER1 bis ER31) dieses Binär-Dezimal-Wandlers (von denen einer die Lage des Fehlers angibt) an die erwähnten äußeren Eingänge der EXKLUSIV-ODER-Kreise (C33 bis C3) angeschlossen sind, die je vor einer der k Kippstufen (D33 bis D3) des letzten Schieberegisters (M'6) liegen, so daß der Fehler korrigiert wird, der sich in diesem Augenblick in diesem Register (M'6) befindet, während gleichzeitig das Aktivierungssignal (40) des Binär-Dezimal-Wandlers (27) verwendet wird, um die erste Kippstufe jedes der p ersten Schieberegister auf null zu setzen, um die Syndrombits zu löschen, die sie enthalten und die gemeinsam die Lage des gleichzeitig korrigierten Fehlers angeben.

3. Vorrichtung zur Kodierung/Dekodierung mit Fehlerkorrektur gemäß Anspruch 1, dadurch gekennzeichnet, daß das Aktivierungstor (37) auch ein äußeres Signal (B1) zur Blockierung der Korrektur empfängt.

4. Vorrichtung zur Kodierung/Dekodierung mit Fehlerkorrektur nach einem der Ansprüche 2 und 3, dadurch gekennzeichnet, daß das Aktivierungssignal (38) und die Signale (20, 28 bis 31), die die Adresse des Fehlers angeben, an den Binär-Dezimal-Wandler über je eine Kippstufe (39, 21, 33 bis 36) vom Typ D angelegt werden.

**Fig.1**

**Fig.2**

12

Fig. 3

EP 0 385 214 B1

**Fig. 4**

EP 0 385 214 B1